# EUROPÄISCHE PATENTANMELDUNG

(11) **EP 0 783 182 A2**
(43) Veröffentlichungstag der Anmeldung: **09.07.1997**
(21) Anmeldenummer: 97100075.7
(22) Anmeldetag: 03.01.1997
(51) Int. Cl.: H01L 27/115

(54) **Schmelzsicherung in einer integrierten Halbleiterschaltung**

(30) Priorität: 08.01.1996 DE 19600398; 20.09.1996 DE 19638666
(71) Anmelder: SIEMENS AKTIENGESELLSCHAFT, 80333 München (DE)
(72) Erfinder: Werner, Wolfgang, Dr.-Ing., 81545 München (DE); Müller, Karlheinz, Ing., 84478 Waldkraiburg (DE); Pöhle, Holger, Dipl.-Ing., 82024 Taufkirchen (DE)

(57) **Zusammenfassung**

Die Erfindung sieht vor, eine Schmelzsicherung (fusible link), die als Leitbahn mit einer Querschnittsverengung als Soll-Schmelzstelle ausgebildet ist, in einem Hohlraum anzuordnen. Die Oberfläche des Hohlraums und/oder der freiliegenden Leitbahn kann zur Verhinderung von Korrosion mit einer Schutzschicht bedeckt werden.Vorteile eines solchen fusible link sind eine geringere Zündenergie und eine erhöhte Zuverlässigkeit. Die Schmelzsicherung kann als Speicherelement eines PROM verwendet werden.

## Beschreibung

Die Erfindung betrifft eine Schmelzsicherung in einer integrierten Halbleiterschaltung, bei der eine Leitbahn eine Querschnittsverengung als Sollschmelzstelle aufweist.

Integrierte Halbleiterschaltungen weisen häufig Schmelzsicherungen, sogenannte fusible links, auf, die zur Einbringung von Information in eine bereits fertiggestellte integrierte Schaltung dienen. Dies geschieht dadurch, daß die Schmelzsicherung gezündet oder nicht gezündet wird, d.h. eine Leitbahn unterbrochen oder nicht unterbrochen ist. Schmelzsicherungen werden beispielsweise zur Sicherung persönlicher Daten in Chipkarten, zur Personalisierung von Standardbausteinen in Kraftfahrzeugen, zur Einstellung von genauen Widerständen oder Widerstandsverhältnissen in analogen Schaltungen, als Speicherelement in einem PROM oder zur Erhöhung der Ausbeute bei Speicherbausteinen durch Abtrennen von defekten Speicherzellen eingesetzt.

Üblicherweise besteht eine Schmelzsicherung aus einer Leitbahn, die an der Sollschmelzstelle eine Verengung ihres Querschnitts aufweist. Dieser verengte Querschnitt weist typischerweise eine vertikale Ausdehnung von 0,1 bis 1 µm und eine horizontale Ausdehnung von 0,5 bis 3 µm auf. Die Schmelzsicherung ist entsprechend der Schichtfolge des Halbleiterbausteins in eine oder mehrere isolierende Schichten, vorzugsweise Siliziumdioxid, eingebettet.

Die Unterbrechung der Leitbahn erfolgt durch einen Stromimpuls, der zum Aufschmelzen der Sicherung und der sie umgebenden Isolationsschicht führt. Bei einer üblichen aus Polysilizium bestehenden Sicherung sind etwa 20 mA bei 12 V für eine Zeitdauer von 5 bis 10 µsec erforderlich, um eine Durchtrennung zu erzielen. Dabei sind nur etwa 1 bis 10 % dieser Zündenergie für das Aufschmelzen der verengten Leitbahn selber erforderlich, d.h. der weitaus überwiegende Teil der Zündenergie wird in die umgebenden Isolationsschichten abgeführt. Ein Problem bei derart unterbrochenen Sicherungen ist die Gefahr der Revitalisierung, d.h. die ursprüngliche Leitfähigkeit wird durch Temperatur- und Spannungseffekte teilweise wieder hergestellt. Beim Zünden schmilzt ein etwa kugelförmiger Bereich mit einem Durchmesser von einigen µm (typischerweise 2 bis 3 µm) auf. Dies führt zu einer Zerstörung der umliegenden Schichten, insbesondere der überliegenden Passivierungsschicht. Dadurch können Verunreinigungen wie beispielsweise Alkaliionen leichter eindringen und die Zuverlässigkeit der Bauelemente der integrierten Schaltung beeinträchtigen.

Fusible links werden auch als Speicherelement bei PROM-Speicherbausteinen eingesetzt. Dabei besteht eine Speicherzelle aus einem fusible link und einer Diode. Da die Leistungen zum Durchschmelzen sehr hoch sind und die erreichte Zuverlässigkeit gering, werden alternativ solche Speicher mit sogenannten Floating Gate- oder SONOS-Strukturen realisiert. Zum Programmieren wird der Fowler-Nordheim-Tunneleffekt oder Hot-Electron-Injektion verwendet. Nachteilig beim Fowler-Nordheim-Tunneleffekt sind die erforderlichen hohen Programmierspannungen von etwa 15 V, die Schreibzeiten liegen bei etwa 10 µsec bis 1 msec. Bei der Programmierung mittels Hot-Electron-Injektion sind relativ hohe Ströme von einigen mA notwendig bei Schreibzeiten von ca. 10 µsec.

Der Erfindung liegt die Aufgabe zugrunde, eine Schmelzsicherung für eine integrierte Schaltung anzugeben, die eine verbesserte Zuverlässigkeit aufweist und die Zuverlässigkeit der integrierten Schaltung nicht beeinträchtigt. Ferner soll sie als Speicherelement geeignet sein. Diese Aufgabe wird durch eine Schmelzsicherung mit den Merkmalen des Patentanspruchs 1 gelöst.

Bei der Erfindung ist die Soll-Schmelzstelle der Schmelzsicherung in einem Hohlraum untergebracht. Es muß daher nur die verengte Leitbahn selber, jedoch keine umliegende Isolationsschicht aufgeschmolzen werden. Es sind also nur noch etwa 1 bis 10 % der üblichen Zündenergie erforderlich. Dadurch wird der Platzbedarf für die Zündtransistoren verringert. Die Ausbeute beim Zündvorgang wird ebenfalls verbessert. Die Gefahr der Revitalisierung wird vermieden. Da der Schmelzvorgang auf die Leitbahn beschränkt ist, werden darüber angeordnete Schutzschichten der integrierten Schaltung, wie beispielsweise Getter- und Barriereschichten, nicht zerstört, so daß die Zuverlässigkeit der übrigen Bauelemente nicht verringert wird.

Bei einer derartigen Schmelzsicherung kann jedoch die Gefahr des Eindringens schädlicher Substanzen wie beispielsweise Feuchtigkeit in den Hohlraum bestehen. An den Hohlraumwänden, an denen auch leitende Strukturen freiliegen können, und an der Schmelzsicherung selbst kann es zu unerwünschten Reaktionen kommen, die die Funktionsfähigkeit und Zuverlässigkeit der Schmelzsicherung oder der Schaltung beeinträchtigen. In einer Weiterbildung der Erfindung ist daher vorgesehen, die Schmelzsicherung und/oder den Hohlraum mit einer Schutzschicht zu bedecken, um Reaktionen an den freiliegenden Oberflächen der Leitbahn und/oder des Hohlraums, insbesondere Korrosion, zu vermeiden. Geeignete Schutzschichten sind beispielsweise Siliziumoxid, Siliziumnitrid oder eine Doppelschicht aus diesen Materialien. Die Schicht kann mit einem bekannten Herstellverfahren, bspw. PECVD, aufgebracht werden. Die Schichtdicke ist entsprechend den Anforderungen zu wählen und liegt vorzugsweise im Bereich 100 bis 1000 nm.

Die beschriebene Schmelzsicherung kann als Speicherelement eingesetzt werden, indem sie in Serie mit einer Diode oder mit einem Drain eines Auswahltransistors geschaltet wird. Ein wesentlicher Vorteil ist, daß zur Programmierung weder ein hoher Strom noch eine hohe Spannung notwendig sind. Beträgt beispielsweise der Querschnitt der Soll-Schmelzstelle 0,4 x 0,7 µm² bei einer Polysiliziumbahn, so beträgt der Fusestrom ca. 5 mA bei einer Spannung von etwa 4 V. Diese Werte können durch die Wahl von kleineren Querschnitten weiter verringert werden. Die Zeit für die Programmierung einer solchen Zelle beträgt weniger als eine µsec. Ein weiterer Vorteil besteht darin, daß die gespeicherten Daten sicher sind, da ein Löschen und Neuschreiben grundsätzlich nicht mehr möglich ist. Auch durch Strahlung oder Temperaturlagerung können die Daten nicht verändert werden.

Die Erfindung wird im folgenden anhand von Ausführungsbeispielen näher erläutert.
- FIG 1 bis 5: zeigen einen Ausschnitt aus einem Halbleitersubstrat in Querschnitt bzw. in Draufsicht, an dem die Herstellung einer ersten Ausführungsform der Schmelzsicherung verdeutlicht wird.
- FIG 6 bis 10: zeigen weitere Ausführungsformen der Schmelzsicherung..

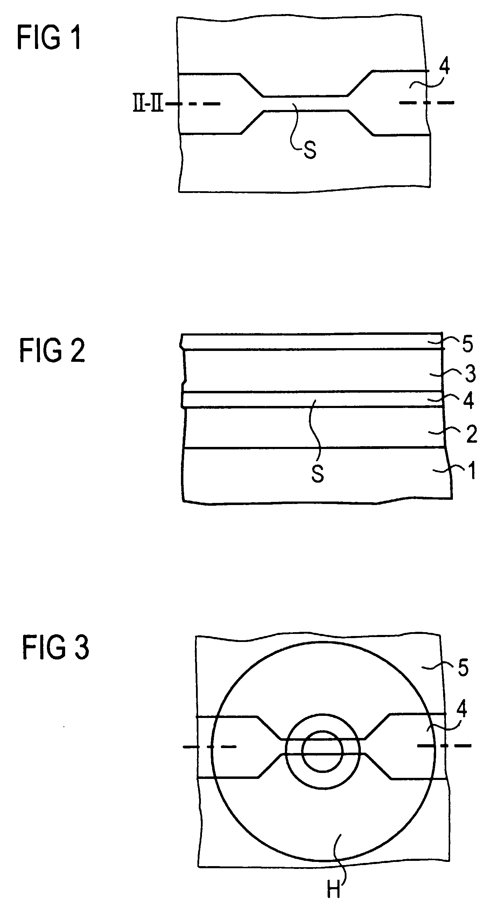

FIG 1 und 2: Auf einem Halbleitersubstrat 1 befinden sich eine untere und eine obere Isolationsschicht 2, 3, die eine Leitbahn 4 umgeben. Die untere und die obere Isolationsschicht 2, 3, die vorzugsweise aus Siliziumoxid bestehen, bilden zusammen eine erste Schicht. Wie in FIG 1 erkennbar, besitzt die in die erste Schicht eingebettete, vorzugsweise aus Polysilizium bestehende Leitbahn 4 eine Querschnittsverengung, die in diesem Fall durch die Verringerung ihrer Breite erzeugt wird. Diese Querschnittsverengung stellt die Sollschmelzstelle S der Leitbahn 4 dar. Auf der oberen Isolationsschicht 3 ist eine zweite Schicht 5 aufgebracht, die beispielsweise wiederum aus Polysilizium besteht (in FIG 1 nicht dargestellt).

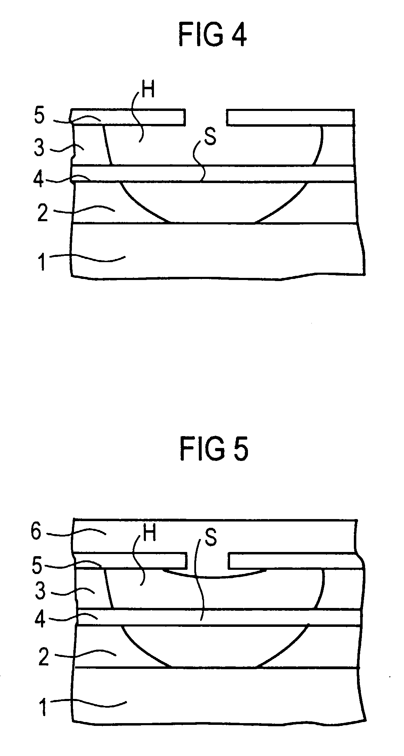

FIG 3 und 4: Vorzugsweise direkt oberhalb der Soll-Schmelzstelle S wird in der zweiten Schicht 5 eine Öffnung erzeugt, beispielsweise in einem anisotropen Ätzprozeß unter Verwendung einer Fotolackmaske. Anschließend wird in der darunterliegenden ersten Schicht 2, 3 ein Hohlraum erzeugt, derart, daß die Soll-Schmelzstelle S innerhalb dieses Hohlraums liegt. Dafür kann ein isotroper Ätzprozess eingesetzt werden, der selektiv zum Leitbahnmaterial und zur zweiten Schicht verläuft. Es wird ein Hohlraum mit einem Durchmesser von etwa 1 bis 3 µm hergestellt.

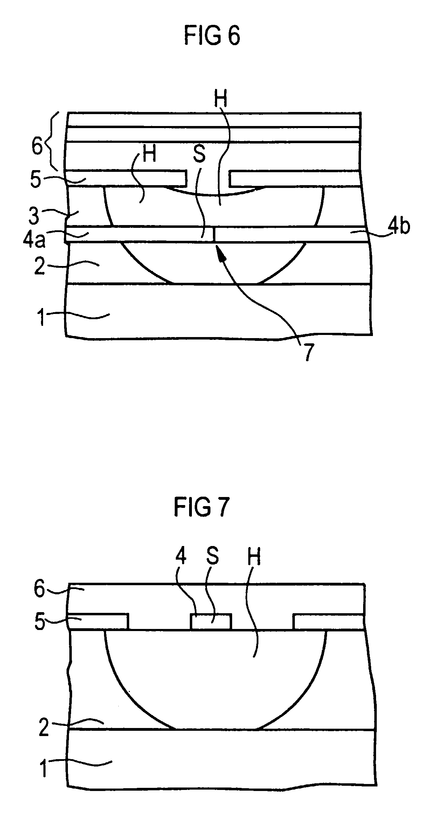

FIG 5: Anschließend kann der Hohlraum verschlossen werden, in dem eine Deckschicht aus Siliziumnitrid, BPSG, TEOS oder einem anderen geeigneten Material oder eine Mehrfachschicht, die vorzugsweise diese Komponenten enthält, aufgebracht wird. Bei Verwendung von BPSG als Deckschicht kann dieses anschließend in einem Temperaturschritt verflossen werden, wodurch eine ebene, spannungsfreie und hoch belastbare Abdeckung entsteht.

FIG 6: Die Schmelzsicherung kann wie oben erläutert, als Speicherelement eingesetzt werden. In einer Ausführungsform wird sie als eine Einheit mit der Diode hergestellt, indem die Leitbahn 4 selber einen pn-Übergang 7, vorzugsweise in unmittelbarer Nähe der Sollschmelzstelle, aufweist. Die Leitbahn 4 besteht also aus einem p-dotierten Teil 4b. Die Deckschicht 6 kann eine Mehrfachschicht sein, bspw. eine in der Halbleitertechnologie übliche Abdeckung aus BPSG, TEOS und Siliziumnitrid.

FIG 7: die Erfindung umfaßt auch eine Ausführungsform, bei der die Sollschmelzstelle S nicht vollständig im Hohlraum liegt, sondern nur eine Oberfläche der Leitbahn 4 an den Hohlraum angrenzt. Die zweite Schicht 5 kann dann mit der Schicht, aus der die Leitbahn hergestellt wird, identisch sein. Vorzugsweise wird sie derart strukturiert, daß sie als Maske bei der Ätzung des Hohlraums dient. Direkt neben der Leitbahn weist die zweite Schicht 5 die für den Ätzprozeß notwendigen Öffnungen auf. Das Herstellverfahren wird dadurch stark vereinfacht, wobei die wesentlichen Vorteile der Erfindung weiterhin in etwas verringertem Maß erreicht werden.

In der Figur verläuft die Leitbahn 4 senkrecht zur Zeichenebene, der Schnitt verläuft durch die Sollschmelzstelle S. Die untere Oberfläche der Sollschmelzstelle liegt im Hohlraum.

Die Schmelzsicherung kann auch aus einer anderen leitenden Schicht anstelle des Polysiliziums hergestellt werden, beispielsweise aus Aluminium oder einem anderen für die Metallisierung der integrierten Schaltung verwendeten Metall oder Legierung. Für das Freiätzen des Hohlraums ist dann ein jeweils geeignetes Verfahren anzuwenden. Bei Verwendung von Aluminium kann beispielsweise HF-Dampf eingesetzt werden.

Die integrierte Schaltung mit der Schmelzsicherung kann wie gewohnt weiter verarbeitet werden, da der verschlossene Hohlraum beispielsweise dem beim Einbau in ein Plastikgehäuse auftretenden Druck ohne weiteres Stand hält. Das Verfahren zur Herstellung der Schmelzsicherung selber ist einfach, da nur eine unkritische Fototechnik und ein einfacher Naßätzschritt erforderlich sind.

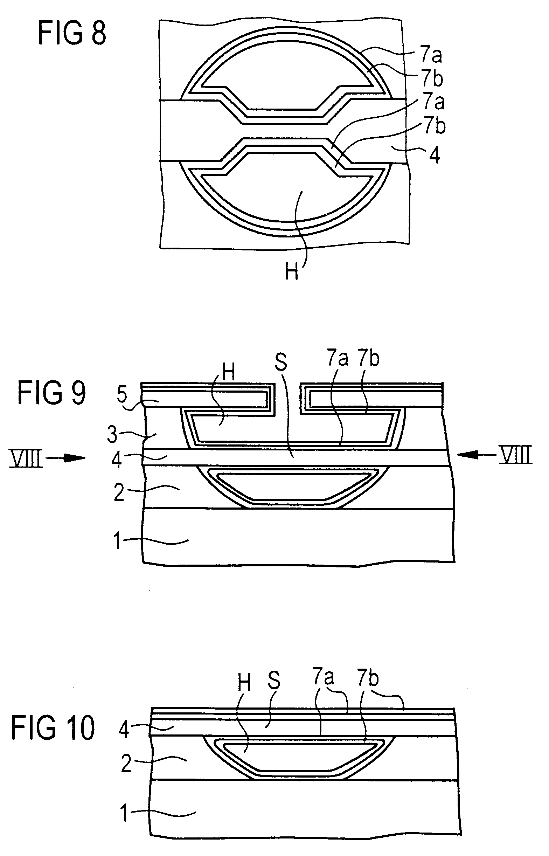

Figur 7 und 8: in diesem Ausführungsbeispiel befinden sich, wie bereits beschrieben, auf einem Halbleitersubstrat 1 eine untere und eine obere Isolationsschicht 2, 3, die eine Leitbahn 4 umgeben. Die beispielsweise aus Polysilizium oder Aluminium bestehende Leitbahn 4 besitzt eine Querschnittsverengung, die in diesem Fall durch die Verringerung ihrer Breite erzeugt wird und die Sollschmelzstelle S der Leitbahn 4 darstellt. Auf der oberen Isolationsschicht 3 ist in diesem Ausführungsbeispiel eine weitere (zweite) Schicht 5 aufgebracht, die beispielsweise wiederum aus Polysilizium oder Aluminium besteht und die eine Öffnung oberhalb der Sollschmelzstelle S aufweist. Mit Hilfe eines im wesentlichen isotropen Ätzprozesses wird durch diese Öffnung hindurch der Hohlraum H erzeugt, so daß die Sollschmelzstelle S innerhalb dieses Hohlraums liegt. Nun erfolgt eine ganzflächige Abscheidung von Siliziumoxid 7a und darüber Siliziumnitrid 7b mittels PECVD, wobei auch die freiliegende Unterseite der Leitbahn 4 mit dieser Schutzschicht bedeckt wird.

Anschließend kann, wie oben beschrieben, der Hohlraum mit einem planarisierenden Deckel verschlossen werden, ferner kann die Schutzschicht von Oberflächen außerhalb des Hohlraums H, also von der oberen Oberfläche der zweiten Schicht 5, wieder entfernt werden.

Figur 10: In Abänderung des zuvor beschriebenen Verfahrens wird der Hohlraum H nach Strukturierung der Leitbahn 4 hergestellt, indem mit Hilfe einer geeigneten Fotomaske um die Leitbahn, insbesondere um die Sollschmelzstelle herum, nach unten geätzt wird. Dann erfolgt wie oben die Herstellung der Schutzschicht 7a, 7b.

## Patentansprüche

1. Schmelzsicherung in einer integrierten Halbleiterschaltung, bei der eine Leitbahn (4) eine Querschnittsverengung als Sollschmelzstelle (S) aufweist,
**dadurch gekennzeichnet,** daß
die Sollschmelzstelle (S) zumindest mit einer ihrer Oberflächen in einem Hohlraum (H) angeordnet ist.

2. Schmelzsicherung nach Anspruch 1, bei der der Hohlraum in einer die Leitbahn (4) umgebenden ersten Schicht (2, 3) auf einem Halbleitersubstrat (1) gebildet ist.

3. Schmelzsicherung nach einem der Ansprüche 1 bis 2, bei der der Hohlraum mit einer Deckschicht (6) abgedeckt ist.

4. Schmelzsicherung nach Anspruch 3, bei der die Deckschicht (6) eine BPSG-Schicht umfaßt.

5. Schmelzsicherung nach einem der Ansprüche 1 bis 4, bei der die Sollschmelzstelle (S) etwa in der Mitte des Hohlraums angeordnet ist.

6. Schmelzsicherung nach einem der Ansprüche 1 bis 5,
bei der auf dem Hohlraum eine zweite Schicht (5) mit einer Öffnung und eine Deckschicht (6), die die Öffnung verschließt, angeordnet sind.

7. Schmelzsicherung nach einem der Ansprüche 1 bis 6,
bei der die Oberfläche des Hohlraums H und/oder die freiliegende Oberfläche der im Hohlraum angeordneten Leitbahn 4 mit einer Schutzschicht 7 bedeckt ist.

8. Schmelzsicherung nach Anspruch 7,
bei der die Schutzschicht (7) aus Siliziumnitrid oder Siliziumoxid besteht.

9. Schmelzsicherung nach einem der Ansprüche 7 bis 8, bei der die Schutzschicht (7) aus einer Doppelschicht (7a, b) aus Siliziumnitrid und Siliziumoxid besteht.

10. Schmelzsicherung nach einem der Ansprüche 1 bis 9, bei dem die Leitbahn (4) einen p-n-Übergang (7) innerhalb des Hohlraums aufweist, der eine Diode darstellt.

11. Herstellverfahren für eine Schmelzsicherung in einer integrierten Schaltung nach einem der Ansprüche 1 bis 10 mit folgenden Schritten:
- Herstellung einer Leitbahn (4) mit einer Querschnittsverengung als Sollschmelzstelle (S), die in einer auf einem Halbleitersubstrat (1) angeordneten ersten Schicht (2, 3) eingebettet ist,
- Herstellen einer zweiten Schicht (5), die eine Öffnung in der Nähe der Sollschmelzstelle (S) aufweist, auf der ersten Schicht (2, 3),
- Erzeugen eines Hohlraumes in der ersten Schicht (2, 3) um die Sollschmelzstelle herum mit Hilfe eines Ätzprozesses.

12. Herstellverfahren für eine Schmelzsicherung in einer integrierten Schaltung nach einem der Ansprüche 1 bis 10 mit folgenden Schritten:
- Herstellen einer ersten Schicht (2) auf einem Halbleitersubstrat,
- Herstellen einer zweiten Schicht (5) auf der ersten Schicht (2), die eine Leitbahn (4) mit einer Querschnittsverengung als Sollschmelzstelle (3) und dazu benachbarte Öffnungen umfaßt,
- Erzeugen eines Hohlraumes (H) in der ersten Schicht (2) unterhalb der Sollschmelzstelle.

13. Herstellverfahren nach Anspruch 11 oder 12, bei dem die Öffnung in der zweiten Schicht (5) mit Hilfe einer Deckschicht (6) verschlossen wird.

14. Herstellverfahren nach Anspruch 13, bei dem die Deckschicht (6) aus BPSG besteht.

15. Herstellverfahren nach einem der Ansprüche 11 bis 14, bei dem die Schmelzsicherung in Serienschaltung mit einer Diode oder dem Drain eines Auswahltransistors verbunden wird.

16. Herstellverfahren nach Anspruch 15, bei dem die Leitbahn (4) einen p-n-Übergang (7) innerhalb des Hohlraums aufweist, der die Diode darstellt.

17. Herstellverfahren nach einem der Ansprüche 11 bis 16, bei dem nach der Erzeugung des Hohlraums (H) eine Schutzschicht (7) auf der Hohlraumwand und/oder auf der freiliegenden Oberfläche der Leitbahn (4) aufgebracht wird.

18. Verwendung einer Schmelzsicherung nach einem der Ansprüche 1 bis 10, als Speicherelement in einer Speicherzelle eines Halbleiterbauelementes.
